# EUROPÄISCHE PATENTSCHRIFT

(11) **EP 0 594 654 B1**
(45) Veröffentlichungstag und Bekanntmachung des Hinweises auf die Patenterteilung: **24.01.1996**
(21) Anmeldenummer: 92913733.9
(22) Anmeldetag: 27.06.1992
(51) Int. Cl.: H05K 13/02, B23Q 35/10, B23Q 5/34, H01L 21/00

(54) **WERKZEUGMASCHINE MIT KURVENGETRIEBE, INSBESONDERE ZUM STANZEN UND FORMEN DER ANSCHLUSSBEINCHEN VON INTEGRIERTEN SCHALTKREISEN**
MACHINE TOOL WITH CURVED DRIVE, ESPECIALLY FOR STAMPING AND SHAPING THE CONNECTING PINS OF INTEGRATED CIRCUITS
MACHINE-OUTIL AVEC COMMANDE A CAMES, EN PARTICULIER POUR L'ESTAMPAGE ET LE FORMAGE DES PATTES DE CONNEXION DE CIRCUITS INTEGRES

(30) Priorität: 16.07.1991 DE 4123512
(43) Veröffentlichungstag der Anmeldung: 04.05.1994
(73) Patentinhaber: MICRON TECHNOLOGY, INC., Boise, ID 83706-9698 (US)
(72) Erfinder: HINTERLECHNER, Gerhard, D-75180 Pforzheim (DE); GÄBEL, Ulrich, Hans, D-75305 Neuenbürg (DE)
(74) Vertreter: Twelmeier, Ulrich, Dipl.Phys.
(86) Internationale Anmeldenummer: EP9201449
(87) Internationale Veröffentlichungsnummer: WO9302539

(56) Entgegenhaltungen:
- DE-A- 3 103 525
- US-A- 3 219 068

## Beschreibung

### Technisches Gebiet

Die Erfindung geht aus von einer Werkzeugmaschine mit den im Oberbegriff des Anspruchs 1 angegebenen Merkmalen.

### Stand der Technik

Eine solche Maschine ist aus der DE-PS 35 44 087 oder aus DE-A-3 103 525 bekannt. In der bekannten Maschine werden die Werkzeuge durch ein Kurvengetriebe angetrieben, welches zwei gleichachsig angeordnete, angetriebene Kurvenscheiben hat. An der als Kurvenbahn ausgebildeten Stirnfläche jeder der beiden Kurvenscheiben liegt eine frei drehbare Rolle an. Jede der beiden Rollen ist am Ende eines zweiarmigen Hebels gelagert, welcher die von der sich drehenden Kurvenbahn bewirkte Auslenkung der Rolle auf eine Werkzeughälfte bzw. auf eine Halterung dafür überträgt, welche am gegenüberliegenden Ende des Hebels angeordnet ist. Die beiden Hebel sind durch eine Zugstrebe miteinander verbunden, an deren Enden die beiden Hebel schwenkbar gelagert sind.

Damit die Rollen stets im Kontakt mit den Kurvenscheiben bleiben, werden sie durch Kraftschluss an die durch deren Stirnseite gebildete Kurvenbahn gedrückt oder gezogen, und zwar im allgemeinen durch Federn. Die durch die Federn aufgebrachten Vorspannkräfte müssen größer sein als die beim Beschleunigen und Abbremsen der Werkzeuge auftretenden Kräfte, um ein Abheben der Rollen von den Kurvenscheiben zu vermeiden. Nachteilig dabei ist, dass diese Vorspannkräfte umgekehrt den Antrieb erschweren, weil sie beim Antreiben der Werkzeuge überwunden werden müssen, so dass man einen entsprechend kräftigen, schweren Antriebsmotor benötigt. Ein weiterer Nachteil ergibt sich daraus, dass das vom Antriebsmotor aufzubringende Drehmoment für den eigentlichen von den Werkzeugen durchgeführten Bearbeitungsvorgang um das Drehmoment erhöht wird, welches benötigt wird, um die auf die Rollen einwirkenden Vorspannkräfte zu überwinden; dadurch muss die Ansprechschwelle einer im Antriebsstrang vorgesehenen Überlastkupplung in unerwünschter Weise angehoben werden, welche die Werkzeuge im Überlastfall vor Schaden bewahren soll. Ein weiterer Nachteil besteht darin, dass eine Einrichtung zur Vorspannung der Rollen durch Federn eine an sich erwünschte Verschiebung der Hebel parallel zur Antriebsachse der Kurvenscheiben behindert; eine solche Verschiebbarkeit ist zur Anpassung der Werkzeugmaschine an unterschiedliche Bearbeitungsaufgaben erwünscht.

Zur Vermeidung der Vorspannkräfte ist es bekannt, die Rolle nicht auf der Stirnseite, sondern in einer Nut der Kurvenscheibe (Nutkurvengetriebe) oder ein Rollenpaar beidseits einer Wulst der Kurvenscheibe (Wulstkurvengetriebe) zu führen. Bei gleichen Abtastverhältnissen wie bei einem Kurvengetriebe, bei dem die Rolle aussen auf der Stirnseite der Kurvenscheibe läuft, haben Nutkurvenscheiben und Wulstkurvenscheiben aber einen größeren Durchmesser, so dass im Kurvengetriebe größere Massenträgheitsmomente auftreten, was unerwünscht ist, weil dadurch entweder die Maschine nur langsamer angehalten werden kann oder die Antriebskräfte und Bremskräfte größer werden und der Verschleiß zunimmt. Die Beschleunigungs- und Bremskräfte der Werkzeughälften und der sie tragenden Aufspanneinrichtungen treten im wesentlichen in Richtung der Werkzeugbewegung auf. Sie sind von Nachteil insbesondere bei einer schnellen Beschleunigungsumkehr, weil die in der Richtung der Werkzeugbewegung auftretenden, von den Werkzeugen und Getriebegliedern ausgehenden Massenträgheitskräfte das Maschinengestell und die Werkstückaufnahme zu Schwingungen anregen, teils mit hoher Anregungsfrequenz. Um der Schwingungsanregung entgegenzuwirken, ist es bekannt, den Scheitelpunkt der Beschleunigungsumkehr in Richtung der Anfahrbeschleunigung zu verschieben, so dass die Bremsverzögerung verkleinert wird, allerdings mit dem Nachteil einer Vergrößerung der Anfahrbeschleunigung.

In der DE-PS 35 44 087 findet sich ferner ein Hinweis, dass die Rückstellung der Werkzeuge über Nocken oder Kurvenscheiben gesteuert werden kann, aber ohne eine, konkrete Angabe, wie das zu geschehen hat und ob das einen Einfluß auf das Schwingungsverhalten hat.

Die erwähnten Nachteile sind besonders gravierend bei Maschinen zum Stanzen und Formen der Anschlußbeinchen von integrierten Schaltkreisen, denn einerseits müssen diese Arbeiten mit hoher Genauigkeit durchgeführt werden, vor allem bei Schaltkreisen, die wegen einer hohen Integrationsdichte viele Beinchen haben, zum anderen ist für eine preiswerte Fertigung ein rascher Arbeitstakt erwünscht, dem jedoch Massenträgheit, die Neigung zu Schwingungen und eine Verschleißerhöhung entgegenstehen. Die Neigung zu Schwingungen ist besonders gravierend, denn nur, wenn die integrierten Schaltkreise ruhig liegen und die Werkzeuge nicht vibrieren, können die Stanz- und Formarbeiten an den grazilen Anschlußbeinchen mit der gewünschten Präzision durchgeführt werden und kann eine Steuerung und Überwachung der Werkzeugmaschine mittels einer Kamera für Bilderkennungs- und Bildvermessungseinrichtungen erfolgen. Zum Vibrieren neigen die ICs, die zunächst mit ihren Anschlußbeinchen noch in vorgestanzten Metallbändern (sogenannten Leadframes) hängen, wenn die Beinchen in einem Arbeitsschritt vom Leadframe abgetrennt sind und die ICs dann nur noch an vier dünnen Stegen im Leadframe hängend weiter bearbeitet werden.

### Darstellung der Erfindung

Der vorliegenden Erfindung liegt die Aufgabe zugrunde, den Werkzeugantrieb in einer Werkzeugmaschine der eingangs genannten Art, insbesondere in einer Maschine zum Stanzen und Formen der Anschlußbeinchen von integrierten Schaltkreisen, so zu gestalten, dass die Neigung zur Anregung von Schwingungen der Werkstückaufnahme (Aufspannplatte) und des Gestells vermindert wird, bzw. ein großer Abstand der Eigenfrequenz der zu bearbeitenden Bauteile und Maschinenteile zur Hauptanregungsfrequenz erhalten wird.

Diese Aufgabe wird gelöst durch eine Werkzeugmaschine mit den im Anspruch 1 angegebenen Merkmalen. Vorteilhafte Weiterbildungen der Erfindung sind Gegenstand der abhängigen Ansprüche.

Bei der erfindungsgemässen Maschine laufen die Rollen der beiden Hebel jeweils auf einer Kurvenbahn aussen auf der Stirnseite von wenigstens einer Kurvenscheibe, doch wird der Kontakt zwischen Kurvenscheibe und Rolle nicht durch mechanische Vorspannung mittels einer Feder sichergestellt, sondern dadurch, dass jeder Kurvenbahn eine zweite, starr mit ihr verbundene Kurvenbahn zugeordnet ist, deren Kurvenprofil dem der ersten Kurvenbahn komplementär ist, und dass jeder der beiden Hebel an seinem einen Schenkel nicht nur eine, sondern zwei frei drehbare Rollen trägt, die in Umfangsrichtung der Kurvenbahn gegeneinander versetzt sind und von denen die eine auf der einen Kurvenbahn und die andere auf der zweiten, dazu komplementären Kurvenbahn abrollt, welche gegenüber der ersten Kurvenbahn einen entsprechenden Versatz aufweist. Durch die komplementäre Ausbildung der Kurvenbahnen kann ohne Vorspannkräfte erzwungen werden, dass die beiden Rollen eines Hebels steten Kontakt mit ihrem Kurvenbahnpaar haben. Der Vorteil dieser Anordnung liegt darin, dass man bei vorgegebenem Abtastverhältnis mit den kleinst möglichen Kurvenscheiben auskommt und insoweit ein niedriges Massenträgheitsmoment gegeben ist, wobei durch die Vermeidung von Vorspannfedern zugleich die Antriebsmomente klein gehalten werden können. Entsprechend klein ist die Amplitude von Schwingungen, zu denen die Maschine angeregt werden kann.

Die Verwendung der zwei in der gewählten Anordnung gegeneinander versetzten Rollen für jeden Hebel hat den großen Vorteil, dass die beim Beschleunigen und Abbremsen auftretenden Kräfte nicht mehr ausschließlich parallel zur Bewegungsrichtung des Werkzeuges in das Maschinengestell eingeleitet, sondern in zwei Richtungen aufgeteilt werden. Die für das Anregen von Schwingungen besonders kritischen Beschleunigungskräfte bei der Rückholbewegung (Leerhub) der Werkzeuge und die Bremskräfte beim Arbeitshub werden erfindungsgemäss in eine Richtung umgelenkt die verschieden ist von der (zweckmässig mit der Richtung der Werkzeugbewegung zusammenfallenden) Richtung der Beschleunigungskräfte beim Arbeitshub. Durch diese Aufteilung der Kräfte in unterschiedliche Richtungen werden die Neigung zur Schwingungsanregung und die Anregungsfrequenz vermindert, und zwar insbesondere in dem bevorzugten Fall, dass die beiden an dem zweiten Schenkel des jeweiligen Hebels befindlichen Rollen bezüglich der Achse der Kurvenscheiben in 90°-Stellung zueinander stehen, so dass die bei der Werkzeugbewegung auftretenden Kräfte i.w. in zwei zueinander senkrechten Richtungen auftreten, von denen die eine für die Schwingungsanregung im Werkstückbereich weniger bedeutsam ist als die andere. Zweckmässigerweise liegen die Achsen der beiden Rollen, welche den Arbeitshub der beiden Werkzeughälften bewirken, parallel zur Bewegungsrichtung der Werkzeughälften in einer gemeinsamen Ebene, welche vorzugsweise auch die Achse der Kurvenbahnen enthält. Dann treten zwar die Beschleunigungskräfte beim Arbeitshub und die Bremskräfte beim Leerhub in Richtung der Werkzeugbewegung auf, die Beschleunigungskräfte beim Leerhub und die Bremskräfte beim Arbeitshub werden aber in eine quer dazu verlaufenden Richtung umgelenkt und vermögen kaum Schwingungen im Werkzeugbereich anzuregen. Das gilt ganz besonders in dem bevorzugten Fall, dass die Führungseinrichtung für die Werkzeuge, welche vorzugsweise eine Platte oder ein Block ist bzw. eine sie tragende Aufspannplatte, waagerecht verläuft und mithin auch die Werkzeugbewegung waagerecht erfolgt und die beiden ersten Rollen der beiden Hebel dementsprechend in einer zur Führungseinrichtung bzw. zur Werkzeugaufspannplatte parallelen Ebene unter dieser gelagert sind; in diesem Fall leiten die zweiten Rollen der Hebel einen wesentlichen Teil der Kräfte nach unten in das Gestell und in das Maschinenfundament ein, so dass während der Beschleunigungsphase im Leerhub und während der Bremsphase im Arbeitshub an den Lagern der Hebel eine schräg zur Werkzeugbewegung gerichtete resultierende Kraft in das Gestell eingeleitet wird. Der Teil der Kräfte, der nach unten in das Gestell und in das Maschinenfundament eingeleitet wird, führt wegen der großen Masse des Gestells und des Fundaments zu weniger Anregung von Schwingungen der Maschine. Die Maschine zeichnet sich deshalb durch einen sehr ruhigen Lauf aus, was bei den hohen Genauigkeitsanforderungen in der Mikromechanik ein bedeutender Vorteil ist. Darüberhinaus ist ein ruhiger Lauf eine Voraussetzung für eine höhere Arbeitsgeschwindigkeit. Zugleich bedeutet ein ruhiger Lauf geringeren Verschleiß und erlaubt den Einsatz einer Kamera für Bilderkennung und Bildvermessung.

Einen weiteren Beitrag zu einer vibrationsarmen Arbeitsweise liefert die Erfindung dadurch, dass die Lage der Kurvenbahnen in Drehrichtung in der Weise aufeinander abgestimmt ist, dass wenigstens für eine Teilmenge der Werkzeughälften die Phase der Beschleunigung einer Werkzeughälfte zusammenfällt mit der Phase der Verzögerung einer anderen Werkzeughälfte. Ein weiterer Vorteil dieser Maßnahme besteht darin, dass die Bewegungsenergie der abzubremsenden Werkzeughälfte zum Antrieb einer anderen Werkzeughälfte eingesetzt und dadurch der Kraftbedarf des Antriebs der Maschine vermindert werden kann; gleichzeitig hat das den Vorteil, dass man eine Überlastsicherung im Antriebsstrang der Maschine mit niedrigerer Ansprechschwelle versehen und die Maschine notfalls schneller stillsetzen kann.

Die beanspruchte Maßnahme, die Lage der Kurvenbahnen in bestimmter Weise aneinander anzupassen, ist dann besonders wirksam, wenn man sie ausnutzt, um die längs der gemeinsamen Achse der Kurvenbahnen aufeinanderfolgend angeordneten Werkzeuge nicht gleichzeitig, sondern zeitlich aufeinanderfolgend arbeiten zu lassen, und zwar in der Weise, dass in beiden Gruppen der Werkzeughälften, welche längs der Achse der Kurvenbahnen angeordnet sind, die Lage der zur jeweiligen Gruppe gehörenden Kurvenbahnen so abgestimmt' ist, dass sowohl beim Arbeitshub als auch beim Leerhub der Werkzeuge die Phase der Verzögerung einer Werkzeughälfte zusammenfällt mit der Phase der Beschleunigung der nächstfolgenden Werkzeughälfte. Auf diese Weise können beim Beschleunigen und Abbremsen verschiedener Werkzeughälften in Richtung der Werkzeugbewegung auftretende Kräfte und schräg dazu auftretende Kräfte zu einer resultierenden Kraft überlagert werden, welche quer, vorzugsweise senkrecht zur Richtung der Werkzeugbewegung wirkt und für eine Schwingungsanregung im Werkzeugbereich wenig wirksam ist, so dass Frequenz und Amplitude der Schwingungsanregung abermals reduziert werden.

Sinnvoll ist es aber auch, bei den Kurvenscheiben, die zu ein und demselben Werkzeug gehören, die Lage der Kurven so aufeinander abzustimmen, dass beim Arbeitshub die Phase der Beschleunigung der ersten Werkzeughälfte zusammenfällt mit der Phase der Verzögerung der zweiten Werkzeughälfte, wohingegen beim Leerhub die Phase der Verzögerung der ersten Werkzeughälfte zusammenfällt mit der Phase der Beschleunigung der zweiten Werkzeughälfte. Dadurch läßt sich zwar die Anregungsfrequenz nicht weiter senken, wohl aber die Antriebsleistung und auch die Anregungsamplitude.

Eine weitere Senkung der Anregungsfrequenz kann man erreichen, wenn man stattdessen bei beiden Hälften eines Werkzeugs die Lage der Kurven der zugehörigen Kurvenscheiben so abstimmt, dass beim Arbeitshub ebenso wie beim Leerhub die Phase der Beschleunigung einer der Werkzeughälften zusammenfällt mit der Phase der Verzögerung der anderen Werkzeughälfte.

Das unbewegliche Teil des Kurvengetriebes, an dem die Hebel gelagert sind, ist zweckmässigerweise eine Zugstrebe.

Vorzugsweise wird die Zugstrebe durch die Aufspannplatte für die Werkzeuge selbst gebildet. Das hat den Vorteil, dass die Aufspannplatte nur auf Zug beansprucht wird. Sie wird deshalb beim Preß- und Druckvorgang nicht verformt, sondern im Gegenteil durch die Zugkräfte sogar gestreckt. Das kommt einer präzisen Lagerung der zu bearbeitenden Werkstücke und einer präzisen Führung der Werzeuge sehr entgegen, was bei mikromechanischen Bearbeitungen, wie sie an mikroelektronischen Bauteilen nötig sind, ein wesentlicher Vorteil ist.

Dass man die Hebel nahe bei den Werkzeugen, vorzugsweise unmittelbar an der Aufspannplatte anlenkt, hat den weiteren Vorteil, dass damit ein kompakter Aufbau der Werkzeug- und Getriebeanordnung optimal möglich ist, der weiterhin dadurch gefördert wird, dass erfindungsgemäss die zweiten Rollen eines jeden Hebels nahe bei den Werkzeugen, vorzugsweise dicht unter der Aufspannplatte oder sogar in einer Ausnehmung der Aufspannplatte angeordnet werden. Dadurch werden die Hebel sehr kurz und trägheitsarm.

Nach einem weiteren bevorzugten Merkmal der Erfindung ist die zweite Rolle eines jeden Hebels, welche in der unmittelbaren Nachbarschaft der Werkzeuge bzw. der Aufspannplatte liegt, kleiner als die erste Rolle. Das ist möglich, weil sie nicht die höheren Bearbeitungskräfte übertragen muss, denn diese werden von den beiden anderen, einander diametral gegenüberliegenden ersten Rollen übertragen.

Weil die zweiten Rollen kleiner sein können, wird nochmals ein dichteres Heranrücken der Kurvenbahnen an die Aufspannplatte möglich, verbunden mit einer entsprechenden Verkürzung der beiden Hebel, was sich wiederum günstig in einer Verkleinerung der Massenträgheit auswirkt. Die geringe Massenträgheit in Kombination mit dem Antrieb über komplementäre Kurvenbahnen hat zur Folge, dass man zur Beschleunigung mit einem kleinen Antriebsmoment auskommt, welches unterhalb der reinen Bearbeitungsmomente liegt, so dass es möglich ist, im Antriebsstrang des Kurvengetriebes eine Überlastkupplung mit entsprechend niedriger Ansprechschwelle vorzusehen. Ausserdem verkleinert jede Verkleinerung der Antriebsmomente die Kräfte, die zur Anregung von Schwingungen führen können.

Für ein schwingungsarmes, präzises Arbeiten der Werkzeuge ist auch eine spielfreie Kopplung der Hebel, welche die Werkzeuge betätigen, mit den Kurvenbahnen von Bedeutung. Hier bewährt sich einmal mehr der Antrieb der Werkzeuge über komplementäre Kurvenbahnen, die von je zwei in Umfangsrichtung gegeneinander versetzten Rollen am einen Schenkel eines zweischenkligen Hebels abgetastet werden. Ein besonders geringes Spiel in der Kopplung der Hebel mit den Kurvenbahnen erreicht man nämlich bei einer Weiterbildung der Erfindung, gemäss welcher der die Rollen tragende Schenkel der Hebel in einen Hauptschenkel, der die erste Rolle trägt, und einen demgegenüber schwächeren Nebenschenkel verzweigt ist, der die zweite Rolle trägt. Der Nebenschenkel kann schwach ausgebildet sein, weil er nur die für das Rückholen der Werkzeuge (Leerhub) benötigten Kräfte übertragen können muss, und diese Kräfte sind sehr viel geringer als die Kräfte, die der Hauptschenkel beim Arbeitshub übertragen muss. Während der Hauptschenkel gemessen an den auftretenden Kräften starr sein muss, kann der Nebenschenkel demgegenüber so schwach sein, dass er, wenn die Rollen den Kurvenbahnen mit etwas Druck angelegt werden, elastisch gebogen wird. Auf diese Weise erreicht man, dass die Rollen unter Ausnutzung des Zurückfederns des schwachen Nebenschenkels den Kurvenbahnen absolut spielfrei anliegen, wenn die Lage der Schwenkachse des Hebels in Bezug auf die Kurvenscheiben so gewählt ist, dass die Rollen ständig mit leichtem Andruck den Kurvenbahnen anliegen. Solange die Rollen den Kurvenbahnen spielfrei anliegen, kann es zu einer zusätzlichen Schwingungsanregung durch ein Kurvenspiel nicht kommen, und das ist umso länger gewährleistet, je schwächer der Nebenschenkel des Hebels ist, denn je schwächer der Nebenschenkel ist, desto größer ist der Federweg bei der federnden Anlage der Rolle des Nebenschenkels und desto länger dauert es, bis der Hebel nachgestellt werden oder ausgetauscht werden muss, um Kurvenspiel zu vermeiden.

Die Verwendung von Kurvenscheiben, die aussen abgetastet werden, ermöglicht eine weitere vorteilhafte Weiterbildung der Erfindung, die darin besteht, dass wenigstens die ersten Rollen, die die Kräfte beim Arbeitshub übertragen, vorzugsweise auch die zweiten Rollen, die die Kräfte beim Leerhub übertragen, nicht nur einseitig, sondern beidseitig in ihrem Hebel gelagert sind. Dadurch wird die Anordnung aus Hebel und Rollen besonders steif und dadurch die Betätigung der Werkzeuge und die von ihnen ausgeführte Bearbeitung besonders präzise.

In vorteilhafter Weiterbildung der Erfindung sind die Hebel in Lagerböcken gelagert, welche längs der Aufspannplatte verschiebbar sind. Dadurch sind die Werkzeugstationen bequem längs der Aufspannplatte verstellbar; die Kurvenscheiben sind natürlich entsprechend längs der Welle, auf der sie befestigt sind, verschiebbar. Die Hebel können mit ihren Lagerböcken zur Auf- und Abrüstung senkrecht zu ihrer seitlichen Aufspannfläche an der Werkzeugaufspannplatte entnommen werden.

Der Erfindungsgedanke kann auch übertragen werden auf Werkzeugmaschinen, in denen eine bewegliche Werkzeughälfte (Stempel) gegen eine feststehende Werkzeughälfte (Matrize) arbeitet, so dass nur ein Hebel und ein Paar aus Kurvenbahn und Komplementärkurvenbahn benötigt wird. Eine solche Maschine ist Gegenstand des unabhängigen Anspruchs 2.

### Wege zur Ausführung der Erfindung

Zur weiteren Erläuterung der Erfindung dienen die beigefügten Zeichnungen.
- Figur 1: zeigt schematisch die Anordnung eines Kurvengetriebes und einer Werkzeugaufspannplatte mit Werkzeugaufspanneinrichtungen in einer Werkzeugmaschine mit Blickrichtung in Richtung der Antriebswelle des Kurvengetriebes,
- Figur 2: zeigt schematisch und teilweise im Schnitt die Draufsicht auf die Anordnung gemäss Figur 1 bei entfernter Aufspannplatte,
- Figur 3: zeigt ein Beschleunigungsdiagramm.
- Figur 4: zeigt eine Anordnung wie in Figur 1, aber mit geänderter Gestalt der Hebel,
- Figur 5: zeigt als Detail die zweiseitige Lagerung einer Rolle in ihrem Hebel,
- Figur 6: zeigt ein Beschleunigungsdiagramm wie in Figur 3, aber für drei hintereinander angeordnete Werkzeuge,
- Figur 7: zeigt ein Beschleunigungsdiagramm wie in Figur 3, aber für zwei Kurvenscheiben, die zu zwei Hälften ein- und desselben Werkzeugs gehören,und
- Figur 8: zeigt ein Beschleunigungsdiagramm wie in Figur 6 mit einer Angabe der Richtungen der Beschleunigungskräfte.

Auf einem Maschinengestell 10 ist das Gehäuse 11 eines Kurvengetriebes angebracht, welches nach oben hin durch eine waagerechte Aufspannplatte 8 verschlossen ist. Auf der Aufspannplatte 8 werden die Bearbeitungswerkzeuge aufgespannt. Die Werkzeuge bestehen aus zwei gegeneinander arbeitenden Werkzeughälften 12 und 13, welche von der Werkzeugführung 1 in waagerechter Richtung Z gegenläufig und zueinander geführt werden. Um sie hin und her zu bewegen wirken zwei zweiarmige Hebel 3a und 3b auf sie ein, welche um waagerechte Achsen 14 schwenkbar in Lagerböcken 7 gelagert sind, welche durch eine Nut-und-Feder-Verbindung 15 mit der Aufspannplatte 8 verbunden und in deren Längsrichtung verschiebbar sind. Der obere Schenkel 23a bzw. 23b des jeweiligen Hebels ist mit den Werkzeughälften 13 bzw. 12 verbunden. Der untere Schenkel 33a bzw. 33b des jeweiligen Hebels verzweigt sich in zwei Abschnitte, welche an ihrem Ende jeweils eine erste größere Rolle 6a bzw. 6b und eine kleinere Rolle 4a bzw. 4b tragen, die Kurvenbahnen anliegen, die an der Stirnseite von Kurvenscheiben ausgebildet sind. Die Kurvenscheiben sind auf einer gemeinsamen Welle 5 in der Mitte unter der Aufspannplatte 8 befestigt. Die Rolle 6a liegt einer Kurvenscheibe 22a, die Rolle 6b einer Kurvenscheibe 22b, die Rolle 4a einer Kurvenscheibe 21a und die Rolle 4b einer Kurvenscheibe 21b an. Diese vier Kurvenscheiben könnten auch durch eine einzige Scheibe ersetzt werden, auf deren Stirnseite vier Kurvenbahnen ausgebildet sind. Die Rollen 4a und 4b befinden sich unmittelbar unterhalb der Aufspannplatte 8 und ragen teilweise in eine Ausnehmung 18 der Aufspannplatte hinein; sie befinden sich ausserdem in Bezug auf die Welle 5 in etwa in 90°-Stellung zu den Rollen 6a und 6b, welche einander diametral gegenüberliegend etwa in Höhe der Welle 5 angeordnet sind. Die Kurvenbahn der Kurvenscheibe 21a ist komplementär zur Kurvenbahn der Kurvenscheibe 22a und gegenüber dieser in Umfangsrichtung um ca. 90° versetzt. Entsprechend hat die Kurvenscheibe 21b eine Kurvenbahn, welche komplementär zur Kurvenbahn der Kurvenscheibe 22b und dieser gegenüber in Umfangsrichtung um ca. 90° versetzt ist. Durch die gewählte Art der Anordnung sind die Rollen 4a und 4b sowie 6a und 6b praktisch spielfrei auf den Kurvenscheiben 21a, 21b, 22a und 22b geführt und die Hebel 3a und 3b sind optimal kurz.

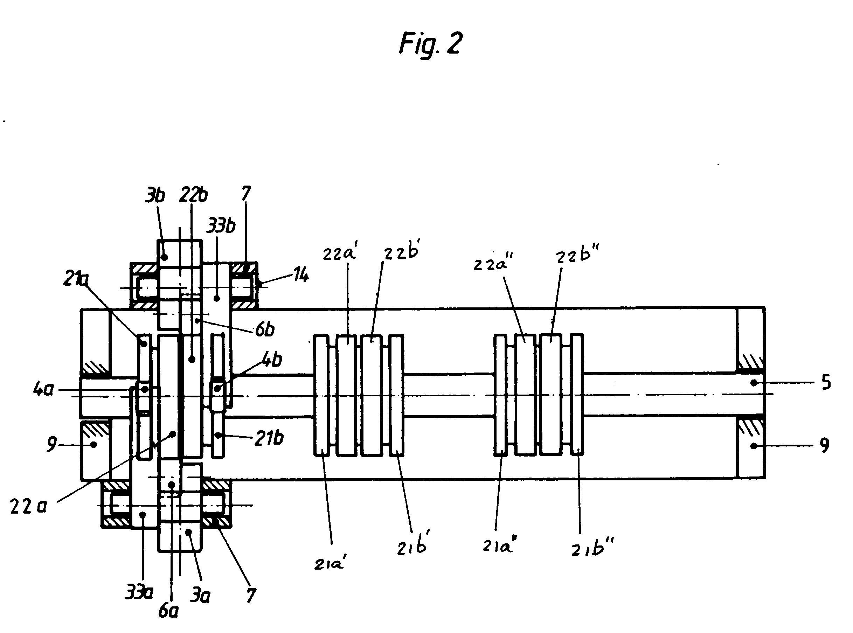

Um in der Werkzeugmaschine mehrere Bearbeitungen gleichzeitig durchführen zu können, sind drei Werkzeugpositionen vorgesehen; bei anderen Ausführungsbeispielen können auch mehr als drei Werkzeugpositionen vorgesehen sein; dementsprechend befinden sich auf der in den Gehäusewänden 9 gelagerten Welle 5 drei Gruppen von Kurvenscheiben, welche vorzugsweise auf der Welle 5 verschiebbar sind (Figur 2). Die erste Gruppe von Kurvenscheiben enthält von links nach rechts die Kurvenscheiben 21a, 22a, 22b und 21b, die zweite Gruppe enthält die Kurvenscheiben 21a', 22a', 22b' und 21b' und die dritte Gruppe enthält die Kurvenscheiben 21a", 22a", 22b" und 21b".

Die Hebel 3a und 3b sind baugleich ausgeführt und einander symmetrisch gegenüberliegend angeordnet. Die beiden Rollen 4a und 6a bzw. 4b und 6b eines jeden Hebels 3a bzw. 3b stellen im Zusammenspiel mit der Lagerung des Hebels um dessen Achse 14 eine formschlüssige Verbindung mit dem jeweiligen Kurvenscheibenpaar 21a und 22a bzw. 21b und 22b her.

Um ein niedriges Massenträgheitsmoment und damit kleine Massenträgheitskräfte der Hebel 3a und 3b bei der Beschleunigung zu erreichen, sind die Hebel so kurz wie möglich, die unteren Schenkel 33a und 33b der beiden Hebel möglichst dicht unter der Aufspannplatte 8 angeordnet und die Rollen 4a und 4b klein ausgebildet, jedenfalls kleiner als die Rollen 6a und 6b, welche die Bearbeitungskräfte übertragen müssen. Die kleinen Rollen 4a und 4b werden nur durch die bei der Beschleunigung auftretenden Massenträgheitskräfte des Hebels 3a bzw. 3b und der reduzierten Masse des bewegten Teils des daran hängenden Werkzeuges belastet. Durch die Anordnung der Rollen 4a und 4b senkrecht über der Welle 5 werden die von ihnen aufgenommenen Beschleunigungskräfte, welche vom Kurvenanstiegswinkel abhängen, im wesentlichen senkrecht in das Maschinengestell und weiter in den Boden eingeleitet. Wegen der dabei beteiligten großen Gestellmasse und der guten Fußdämpfung der Massen wird die Beschleunigungsamplitude stark verkleinert und die Maschine wird deshalb nicht mehr so stark zu Schwingungen angeregt, sondern läuft sehr viel ruhiger, was einerseits zu geringerem Verschleiß führt, andererseits aber auch zu höherer Präzision beim Arbeiten, weil die Werkstücke und die Werkzeuge ruhiger liegen. Die Abstützung der Bearbeitungskräfte in den Werkzeugen übernehmen die Rollen 6a und 6b über die dicht benachbarten Kurvenscheiben 22a und 22b, welche breiter sind als die komplementären Kurvenscheiben 21a und 21b. Hinsichtlich der Bearbeitungskräfte liegt ein geschlossener Kraftfluß vom Werkstück über die Werkzeughälfte 12, den Hebel 3a, die Rolle 6a, die Kurvenscheiben 22a und 22b, die Rolle 6b, den Hebel 3b und die Werkzeughälfte 13 zurück zum Werkstück vor. Die Aufspannplatte 8 wird dabei über die Drehachsen 14 der Hebel nur auf Zug belastet und unterliegt keiner Verformung.

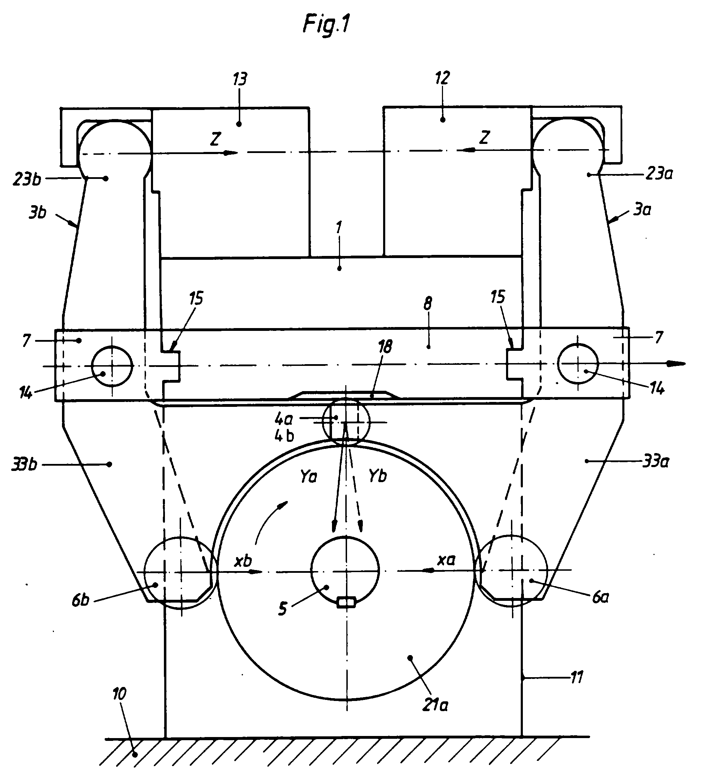

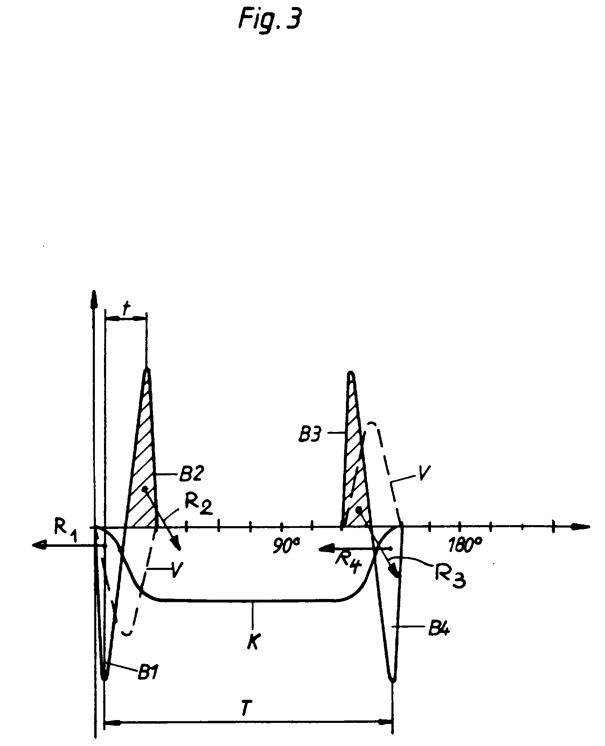

Figur 3 zeigt schematisch am Beispiel eines sich über einen Umfangswinkel von 150° erstreckenden Kurvenverlaufs K den zeitlichen Verlauf der Geschwindigkeit V und der Beschleunigung B an einem Hebel zwischen Kurvenscheibe und Werkzeug sowie durch Pfeile angedeutet die Richtung der an der Achse 14 der Hebel in der jeweiligen Phase auftretenden resultierenden Kräfte. Beim Einfahren einer Werkzeughälfte in Richtung Z auf ein Werkstück erfährt die große Rolle 6a bzw. 6b eine Beschleunigung B1, jedoch übernimmt das Abbremsen der Einfahrbewegung die kleine Rolle 4a bzw. 4b und erfährt dabei die Verzögerung B2. Umgekehrt wird bei der Rückzugsbewegung des Werkzeugs zunächst die kleinere Rolle 4a bzw. 4b belastet und erfährt die Beschleunigung B3, wohingegen das Abbremsen der Rückzugsbewegung über die größere Rolle 6a bzw. 6b erfolgt und diese dabei die Verzögerung B4 erfährt. Da die kleine Rolle 4a bzw. 4b die Beschleunigungskräfte annähernd senkrecht nach unten (Richtung Ya bzw. Yb in Figur 1) über das Gestell 10 in den Boden einleitet und damit praktisch unschädlich macht, kommen für eine Schwingungsanregung in der Ebene der Aufspannplatte 8 nur noch die Massenbeschleunigungskräfte Rund R in Betracht, die von den großen Rollen 6a und 6b übertragen werden. Die Zeitbasis für die Schwingungsanregung ist gegeben durch den zeitlichen Abstand der Maxima von B1 und B4. Würden jedoch wie im Stand der Technik die kleineren Rollen 4a und 4b fehlen, müssten die von ihnen aufgenommenen Beschleunigungskräfte ebenfalls von den Rollen 6a bzw. 6b aufgenommen und übertragen werden; sie würden dann ebenfalls zur Schwingungsanregung in der Ebene der Aufspannplatte 8 beitragen, und zwar mit einer Zeitbasis entsprechend dem Abstand der Maxima von B1 und B2 bzw. von B3 und B4, welcher sehr viel kleiner ist als der Abstand der Maxima von B1 und B4, so dass die Anregungsfrequenzen erfindungsgemäss um ein Mehrfaches unter den Anregungsfrequenzen beim Stand der Technik liegen, was sehr erwünscht ist.

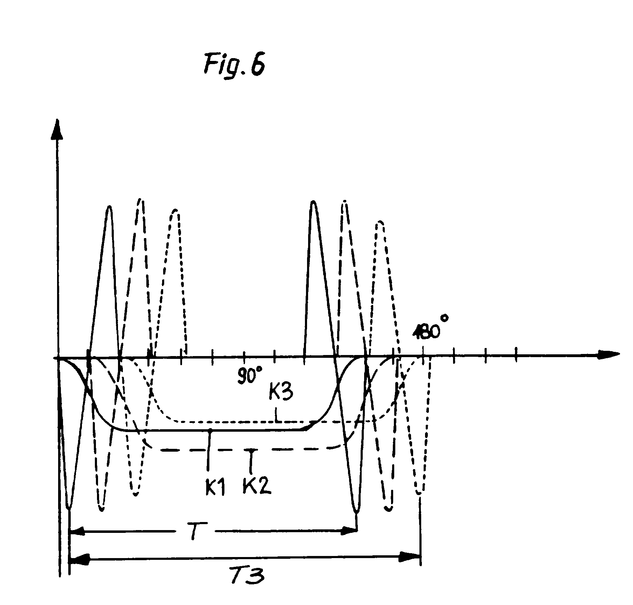

In den Gruppen von Kurvenscheiben, die zu den drei verschiedenen Werkzeugen gehören (siehe Figur 2), ist die Lage der Kurven so aufeinander abgestimmt, dass die Werkzeuge ihren Arbeitshub zeitlich versetzt machen. Das ist in Figur 6 beispielsweise schematisch dargestellt für die Gruppe der Kurvenscheiben 22a, 22a' und 22a". Die Darstellung in Figur 6 entspricht in ihrem Aufbau der Darstellung in Figur 3. Mit K1 ist der Kurvenverlauf auf der Kurvenscheibe 22a, mit K2 der Kurvenverlauf auf der Kurvenscheibe 22a' und mit K3 der Kurvenverlauf auf der Kurvenscheibe 22a" dargestellt. Um die Kurven unterscheiden zu können, ist K1 als durchgezogene Linie, K2 gestrichelt und K3 punktiert dargestellt. Entsprechend sind die beim Beshleunigen bzw. Abbremsen der zugehörigen Werkzeughälfte auftretenden Beschleunigungen bzw. Verzögerungen als durchgezogene, gestrichelte bzw. punktierte Linie dargestellt. Wäre nur die Kurve K1 vorhanden oder wären die Kurven K1, K2 und K3 deckungsgleich, dann wäre wie im Beispiel der Figur 3 die Periode T der in Bewegungsrichtung des Werkzeugs angeregten Schwingungen mit der Hauptanregungsfrequenz 1/T bestimmt durch den Abstand des Beschleunigungsmaximums beim Arbeitshub zum Maximum der Verzögerung beim Leerhub. Wenn jedoch wie dargestellt beim Arbeitshub die von K2 ausgehende Phase der Beschleunigung zusammenfällt mit der von K1 ausgehenden Phase der Verzögerung und die von K3 ausgehende Phase der Beschleunigung zusammenfällt mit der von K2 ausgehenden Phase der Verzögerung und wenn beim Leerhub die von K2 ausgehende Phase der Beschleunigung zusammenfällt mit der von K1 ausgehenden Phase der Verzögerung und die von K3 ausgehende Phase der Beschleunigung zusammenfällt mit der von K2 ausgehenden Phase der Verzögerung, dann werden folgende Kräfte einander überlagert:
R₂ aus der Kurve K1 mit R₁ aus der Kurve K2,
R₂ aus der Kurve K2 mit R₁ aus der Kurve K3,
R₄ aus der Kurve K1 mit R₃ aus der Kurve K2,
R₄ aus der Kurve K2 mit R₃ aus der Kurve K3.

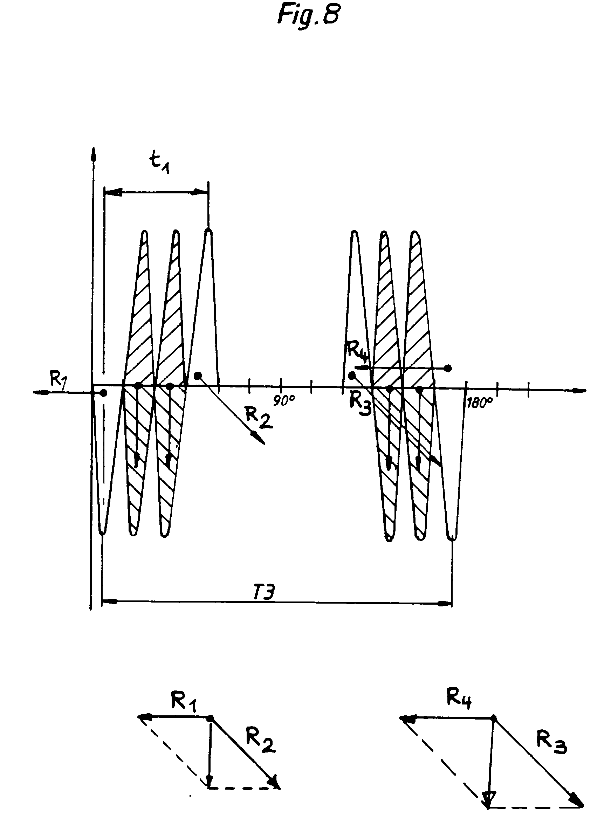

Durch diese Überlagerung erhält man resultierende Kräfte, die i.w. senkrecht nach unten gerichtet sind (siehe Figur 8) und damit für eine Schwingungsanregung praktisch nicht infrage kommen, noch viel weniger als die verbleibenden schräg verlaufenden resultierenden Kräfte R₂ in der Bremsphase des Arbeitshubes von K3 und R₃ in der Beschleunigungsphase des Leerhubes von K1. Es verbleiben für eine in Bewegungsrichtung des Werkzeugs wirksame Schwingungsanregung hauptsächlich die Belastungsspitzen infolge der Beschleunigung, die beim Arbeitshub von K1 ausgeht und infolge der Verzögerung, die beim Leerhub von K3 ausgeht, und deren die Periode der Anregungsschwingung bestimmende Abstand T3 ist größer als T, so dass die Anregungsfrequenz in erwünschter Weise entsprechend niedriger liegt. Je nach Zahl der Werkzeuge und Ausbildung der Kurvenscheiben kann auf diese Weise die Anregungsfrequenz bis zur Hälfte erniedrigt werden.

Durch die erfindungsgemässe Abstimmung der Lage der Kurvenbahnen in den Werkzeuggruppen erreicht man ferner, dass die Zeitspanne zwischen der Beschleunigungsphase beim Arbeitshub von K1 zum Auftreten der nächsten schräg verlaufenden Resultierenden R₂ auf t₁ verlängert und die daraus sich ergebende Schwingungsanregung zu einer weniger wirksamen tieferen Frequenz verschoben wird.

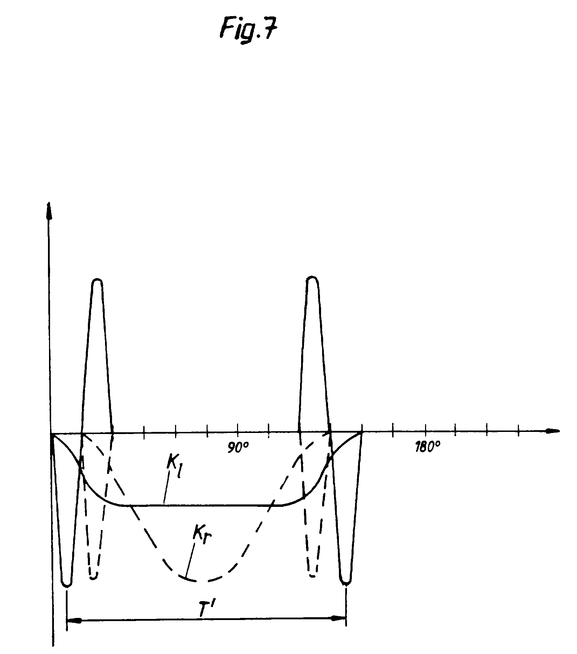

Figur 7 zeigt ein Beispiel, wie zwei Kurvenscheiben, die zu den beiden Werkzeughälften ein und desselben Werkzeuges gehören, vorteilhafterweise mit der Lage ihrer Kurven aufeinander abgestimmt sind. Es kann sich dabei z.B, um die Kurvenscheiben 22a und 22b handeln, wobei zu der Kurvenscheibe 22a die Kurve Kᵣ , zur Kurvenscheibe 22b die Kurve K₁ gehört und die von der Kurvenscheibe 22b bewegte Werkzeughälfte eine Matrize und die von der Kurvenscheibe 22a bewegte Werkzeughälfte ein gegen die Matrize arbeitender Stempel ist. Die Kurven K₁ und Kᵣ sind so aufeinander abgestimmt, dass beim Arbeitshub zunächst die Matrize und dann der Stempel beschleunigt wird, während die Matrize bereits wieder abgebremst wird, so dass die Matrize und mit ihr ein von der Matrize gestütztes Werkstück (IC) bereits in Ruhe ist, bevor der Stempel auf es auftrifft. Beim Öffnen des Werkzeugs (Leerhub) ist es umgekehrt: Hier wird erst der Stempel beschleunigt und dann die Matrize, während der Stempel bereits wieder abgebremst wird. Dabei kann die Bewegungsenergie der abzubremsenden Werkzeughälfte für das Beschleunigen der anderen Werkzeughälfte ausgenutzt werden. Die Periode T' für eine eventuelle Schwingungsanregung in Bewegungsrichtung des Werkzeuges wird hauptsächlich bestimmt durch den Abstand des Beschleunigungsmaximums der Matrize beim Arbeitshub vom Verzögerungsmaximum der Matrize beim Leerhub.

Es sei noch darauf hingewiesen, dass man anhand der Figur 1 anschaulich sieht, dass bei der gewählten Anordnung der kleinen Rollen 4a und 4b in der Mitte über den Kurvenscheiben und dicht unter der Aufspannplatte 8 leicht ein seitliches Herausnehmen der Hebel 3a und 3b senkrecht zur Aufspannfläche der Lagerböcke 7 möglich ist, wodurch eine gute Zugangsmöglichkeit zum Kurvengetriebe und dessen Verstellung gewährleistet wird.

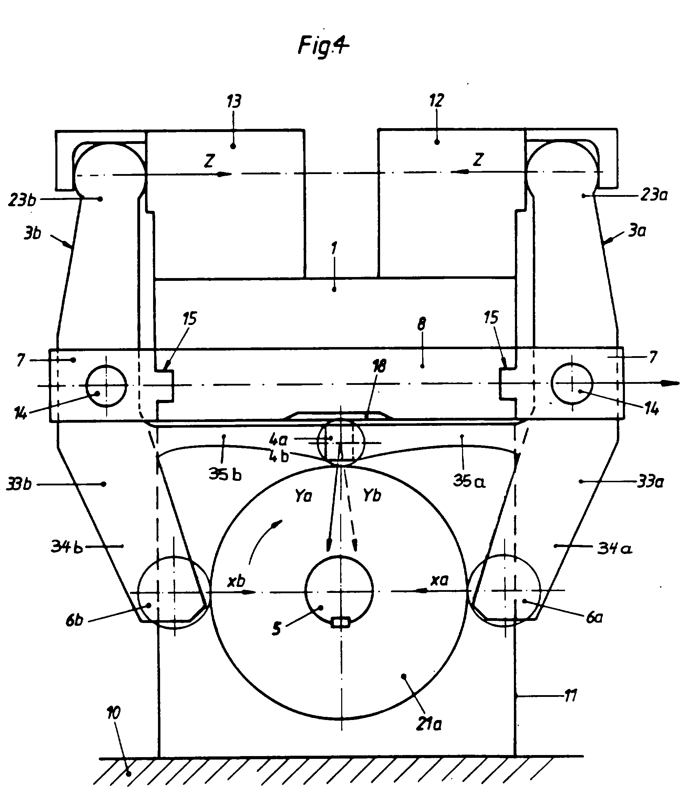

Das Ausführungsbeispiel in Figur 4 unterscheidet sich von dem in Figur 1 darin, dass die Schenkel 33a und 33b der Hebel 3a und 3b in einen kräftigen Hauptschenkel 34a bzw. 34b und in einen demgegenüber wesentlich schwächeren Nebenschenkel 35a bzw. 35b verzweigt sind. Der Hauptschenkel 34a bzw. 34b trägt jeweils die erste Rolle 6a bzw. 6b zur Übertragung der Kräfte beim Arbeitshub. Der Nebenschenkel 35a bzw. 35b trägt jeweils die kleinere Rolle 4a bzw. 4b zur Übertragung der Kräfte beim Leerhub. Weil der Nebenschenkel sehr viel schwächer ist als der Hauptschenkel, kann der Nebenschenkel 35a bzw. 36a etwas zurückfedern, wenn man die beiden Rollen 6a und 4a bzw. 6b und 4b mit etwas Druck auf ihren Kurvenscheiben laufen läßt. Durch die geringe federnde Auslenkung des Nebenschenkels, welche die Antriebsmomente nicht wesentlich erhöht, wird eine absolut spielfreie Kopplung zwischen den Kurvenscheiben 21a, 21b, 22a, 22b und den Rollen 6a, 6b, 4a, 4b, erreicht.

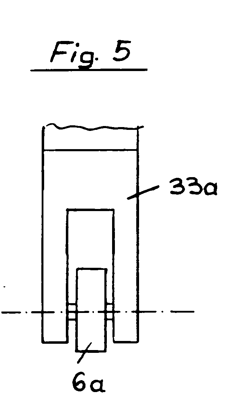

Wie Figur 5 zeigt, ist der Hauptschenkel 34a bzw. 34b zweckmässigerweise gabelförmig ausgebildet und die Rolle 6a bzw. 6b darin beidseitig gelagert, so dass die Anordnung aus Hebel 3a bzw. 3b und Rolle 6a bzw. 6b recht steif ist.

Im Ausführungsbeispiel gemäss Figur 1 oder Figur 4 kann in jeder der drei Werkzeuggruppen eine der Werkzeughälften, z.B. die Werkzeughälfte 13, stationär sein. Dann entfallen die Hebel 3b und die zugehörigen Kurvenscheiben 21b und 22b und eine erfindungsgemässe Abstimmung der Lage der Kurvenbahnen ist nur zwischen Kurvenbahnen möglich, die zu unterschiedlichen Gruppen von Werkzeugen gehören. Auch diese Maschine hat einen ruhigeren Lauf, wenn auch die Welle 5 im Bereich der jeweiligen Werkzeuggruppe einseitig belastet wird.

### Gewerbliche Anwendbarkeit

Die Erfindung ist besonders geeignet für Werkzeugmaschinen zum Stanzen und Formen der Anschlußbeinchen von integrierten Schaltkreisen, welche der Werkzeugmaschine in einem metallischen Trägerband (Leadframe) hängend zugeführt werden.

## Patentansprüche

1. Werkzeugmaschine mit Werkzeugen zum Ausführen von Stanz-, Schnitt-, Präge- und/oder Formarbeiten, insbesondere zum Stanzen und Formen der Anschlußbeinchen von integrierten Schaltkreisen (ICs),
mit einem Gestell (10),
mit einem auf dem Gestell (10) gelagerten Kurvengetriebe mit mehreren Paaren von gleichachsig angeordneten Kurvenbahnen auf der Stirnseite von einer oder mehreren Kurvenscheiben (21a, 21b, 22a, 22b) zum Antreiben der Werkzeuge längs einer Führungseinrichtung (1), wobei jedes Werkzeug zwei gegeneinander arbeitende Werkzeughälften (12, 12) hat, zu deren Betätigung zwei an einem unbewegten Teil (8) des Kurvengetriebes schwenkbar gelagerte zweischenklige Hebel (3a, 3b) vorgesehen sind, die an ihrem ersten Schenkel (23a, 23b) mit jeweils einer Werkzeughälfte (12, 13) verbunden sind und an ihrem zweiten Schenkel (33a, 33b) jeweils eine frei drehbare Rolle (6a, 6b) tragen, wobei die eine Rolle (6a) an der einen Kurvenbahn und die andere Rolle (6b) an der anderen Kurvenbahn eines Kurvenbahnpaares anliegt,
**dadurch gekennzeichnet**,
dass Kurvenbahnpaare vorgesehen sind, wobei die weitere Kurvenbahn mit der ersten Kurvenbahn starr verbunden ist, die weitere Kurvenbahn ein zu der ersten Kurvenbahn komplementäres Kurvenprofil hat und die weitere Kurvenbahn gegenüber der ersten Kurvenbahn in Drehrichtung verzetzt ist und dass die beiden Hebel (3a, 3b) an ihrem zweiten Schenkel (33a, 33b) jeweils noch eine zweite, frei drehbare Rolle (4a, 4b) tragen, welche mit entsprechendem Versatz der weiteren Kurvenbahn auf der Stirnfläche einer Kurvenscheibe (21a, 21b) anliegt und dass die Lage der Kurvenbahnen in Drehrichtung in der Weise aufeinander abgestimmt ist, dass wenigstens für eine Teilmenge der Werkzeughälften (12, 13) gilt, dass die Phase der Beschleunigung einer Werkzeughälfte zusammenfällt mit der Phase der Verzögerung einer anderen Werkzeughälfte.

2. Werkzeugmaschine mit Werkzeugen zum Ausführen von Stanz-, Schnitt-, Präge- und/oder Formarbeiten, insbesondere zum Stanzen und Formen der Anschlußbeinchen von integrierten Schaltkreisen (ICs),
mit einem Gestell (10),
mit einem auf dem Gestell (10) gelagerten Kurvengetriebe mit mehreren gleichachsig angeordneten Kurvenbahnen auf der Stirnseite von einer oder mehreren Kurvenscheiben (21a, 21b, 22a, 22b) zum Antreiben der Werkzeuge längs einer Führungseinrichtung (1), wobei jedes Werkzeug zwei gegeneinander arbeitende Werkzeughälften (12, 13) hat, von denen eines stationär ist und zur Betätigung des anderen ein zweischenkliger Hebel (3a bzw. 3b) vorgesehen ist, der an einem unbewegten Teil (8) des Kurvengetriebes schwenkbar gelagert, an seinem ersten Schenkel (23a bzw. 23b) mit der beweglichen Werkzeughälfte (12 bzw. 13) verbunden ist und an seinem zweiten Schenkel (33a bzw. 33b) eine frei drehbare Rolle (6a bzw. 6b) trägt, welche der Kurvenbahn anliegt, welche zu dem betreffenden Werkzeug gehört,
**dadurch gekennzeichnet**,
dass Kurvenbahnpaare vorgesehen sind, wobei die weitere Kurvenbahn mit der ersten Kurvenbahn starr verbunden ist, die weitere Kurvenbahn ein zu der ersten Kurvenbahn komplementäres Kurvenprofil hat und die weitere Kurvenbahn gegenüber der ersten Kurvenbahn in Drehrichtung verzetzt ist und dass der Hebel (3a, 3b) an seinem zweiten Schenkel (33a, 33b) noch eine zweite, frei drehbare Rolle (4a, 4b) trägt, welche mit entsprechendem Versatz der weiteren Kurvenbahn auf der Stirnfläche einer Kurvenscheibe (21a, 21b) anliegt und dass die Lage der Kurvenbahnen, die unterschiedlichen Werkzeugen zugeordnet sind, in Drehrichtung in der Weise aufeinander abgestimmt ist, dass wenigstens für eine Teilmenge der Werkzeughälften (12 bzw. 13) gilt, dass die Phase der Beschleunigung einer Werkzeughälfte in einem Werkzeug zusammenfällt mit der Phase der Verzögerung einer anderen Werkzeughälfte in einem anderen Werkzeug.

3. Maschine nach Anspruch 1 oder 2, **dadurch gekennzeichnet,** dass in Gruppen von Werkzeughälften, welche längs der Achse (5) der Kurvenscheiben (21a, 21a', 21a", 21b, 21b', 21b"; 22a, 22a' 22a"; 22b. 22b', 22b") aufeinanderfolgend angeordnet sind, die Lage der Kurven der zur einen Gruppe gehörenden Kurvenscheiben so abgestimmt ist, dass sowohl beim Arbeitshub als auch beim Leerhub, der Werkzeuge die Phase der Verzögerung einer Werkzeughälfte zusammenfällt mit der Phase der Beschleunigung der nächst folgenden Werkzeughälfte.

4. Maschine nach Anspruch 1 oder nach Anspruch 1 und 3, **dadurch gekennzeichnet,** dass bei den beiden Hälften (12, 13) eines Werkzeugs die Lage der Kurven der zugehörigen Kurvenscheiben (22a, 22b) so abgestimmt ist, dass beim Arbeitshub die Phase der Beschleunigung der ersten Werkzeughälfte (13) zusammenfällt mit der Phase der Verzögerung der zweiten Werkzeughälfte (12), wohingegen beim Leerhub die Phase der Verzögerung der ersten Werkzeughälfte (13) zusammenfällt mit der Phase der Beschleunigung der zweiten Werkzeughälfte (12).

5. Maschine nach Anspruch 1 oder nach Anspruch 1 und 3, **dadurch gekennzeichnet**, dass bei den beiden Hälften (12, 13) eines Werkzeugs die Lage der zugehörigen Kurvenbahnen so abgestimmt ist, dass beim Arbeitshub ebenso wie beim Leerhub die Phase der Beschleunigung einer der Werkzeughälften zusammenfällt mit der Phase der Verzögerung der anderen Werkzeughälfte.

6. Maschine nach einem der vorstehenden Ansprüche, **dadurch gekennzeichnet**, dass sich die zweiten Rollen (4a, 4b) mit ihren Achsen ungefähr auf einer durch die Achse der Kurvenbahnen gehenden Senkrechten auf der Bewegungsrichtung Z der Werkzeughälften (12, 13) nahe bei diesen befinden.

7. Maschine nach einem der vorstehenden Ansprüche, **dadurch gekennzeichnet,** dass der unbewegte Teil (8) des Kurvengetriebes eine bevorzugt gestellfeste Zugstrebe ist.

8. Maschine nach einem der vorstehenden Ansprüche, **dadurch gekennzeichnet**, dass die Führungseinrichtung (1) für die Werkzeuge sich zwischen diesen und den Kurvenbahnen erstreckt und sich die zweite(n) Rolle(n) (4a, 4b) dicht unter der Führungseinrichtung (1) bzw. einer Werkzeug-Aufspannplatte (8) befinden.

9. Maschine nach einem der vorstehenden Ansprüche, **dadurch gekennzeichnet,** dass sich die zweite(n) Rolle(n) (4a, 4b) bezogen auf die Achse der Kurvenbahnen 22b) in 90°-Stellung zu den ersten Rollen (6a, 6b) befinden.

10. Maschine nach einem der vorstehenden Ansprüche, **dadurch gekennzeichnet**, dass die zweiten Rollen (4a, 4b) im Durchmesser kleiner sind als die ersten Rollen (6a, 6b).

11. Maschine nach einem der vorstehenden Ansprüche, **dadurch gekennzeichnet**, dass die Aufspannplatte (8) die Zugstrebe ist, an welcher die Hebel (3a, 3b) schwenkbar gelagert sind.

12. Maschine nach einem der Ansprüche 8 bis 11, **dadurch gekennzeichnet**, dass die Aufspannplatte (8) waagerecht verläuft.

13. Maschine nach einem der vorstehenden Ansprüche, **dadurch gekennzeichnet**, dass die zweiten Rollen (4a, 4b) der Aufspannplatte (8) unmittelbar benachbart sind.

14. Maschine nach einem der vorstehenden Ansprüche, **dadurch** gekennzeichnet, dass die Aufspannplatte (8) eine Ausnehmung (18) hat, in welche die zweiten Rollen (4a, 4b) hineinragen.

15. Maschine nach einem der vorstehenden Ansprüche, **dadurch gekennzeichnet,** dass die Hebel (3a, 3b) in Lagerböcken (7) gelagert sind, welche parallel zur Achse der Kurvenbahnen, insbesondere längs der Aufspannplatte (8) verschiebbar sind.

16. Maschine nach einem der vorstehenden Ansprüche, **dadurch gekennzeichnet**, dass der die Rollen (6a, 6b, 4a, 4b) tragende Schenkel (33a, 33b) der Hebel (3a, 3b) in einen die erste Rolle (6a, 6b) tragenden Hauptschenkel (3a, 3b) und einen demgegenüber schwächeren, die zweite Rolle (4a, 4b) tragenden Nebenschenkel (35a, 35b) verzweigt ist.

17. Maschine nach Anspruch 16, **dadurch gekennzeichnet,** dass die Rollen (6a, 6b, 4a, 4b) den Kurvenscheiben (21a, 21b, 22a, 22b) durch Druck spielfrei anliegen.

18. Maschine nach einem der vorstehenden Ansprüche, **da-durch gekennzeichnet**, dass wenigstens die ersten Rollen (6a, 6b), vorzugsweise auch die zweiten Rollen (4a, 4b), beidseitig in ihrem Hebel (3a, 3b) gelagert sind.

19. Maschine nach einem der vorstehenden Ansprüche, **dadurch gekennzeichnet,** dass die beiden Rollen (6a, 6b) in Bezug auf das zugehörige Kurvenbahnpaar ungefähr diametral sowie mit ihren Achsen in einer ungefähr parallel zur Werkzeugbewegungsrichtung (Z) verlaufenden Ebene angeordnet sind.

## Claims

1. Machine tool with tools for carrying out punching, cutting, embossing and/or shaping work, in particular for punching and shaping the lead-outs of integrated circuits, having a frame (10), having a cam gear, supported on the frame (10), with a plurality of pairs of coaxially arranged cam tracks on the end face of one or more cam plates (21a, 21b,22a, 22b) for driving the tools along a guide means (1), each tool having two tool halves (12, 13) operating in opposition to one another, for whose actuation two pivotably supported two-arm levers (3a, 3b) are provided on a stationary part (8) of the cam gear, which levers (3a, 3b) are connected at their first arm (23a, 23b) to a respective tool half (12, 13) and carry on their second arm (33a, 33b) a respective freely rotating roller (6a, 6b), the one roller (6a) abutting against the one cam track and the other roller (6a) abutting against the other cam track of a cam track pair, characterized in that cam track pairs are provided, the further cam track being rigidly connected to the first cam track, the further cam track having a cam profile which complements the first cam track, and the further cam track being offset with respect to the first cam track in the direction of rotation, and in that the two levers (3a, 3b) additionally carry on their second arm (33a, 33b) a respective second, freely rotating roller (4a, 4b) which abuts, with a corresponding offset, against the further cam track on the end face of a cam plate (21a, 21b), and in that the positions of the cam tracks in the direction of rotation are matched to one another in such a way that it is true for at least some of the tool halves (12, 13) that the acceleration phase of one tool half coincides with the deceleration phase of another tool half.

2. Machine tool with tools for carrying out punching, cutting, embossing and/or shaping work, in particular for punching and shaping the lead-outs of integrated circuits, having a frame (10), having a cam gear, supported on the frame (10), with a plurality of pairs of coaxially arranged cam tracks on the end face of one or more cam plates (21a, 21b, 22a, 22b) for driving the tools along a guide means (1), each tool having two tool halves (12, 13) operating in opposition to one another, of which one is stationary and a two-arm lever (3a or 3b) is provided for actuating the other, which lever (3a or 3b) is pivotably supported on a stationary part (8) of the cam gear, is connected at its first arm (23a or 23b) to the movable tool half (12 or 13) and carries on its second arm (33a or 33b) a freely rotating roller (6a or 6b) which abuts against the cam track associated with the respective tool, characterized in that cam track pairs are provided, the further cam track being rigidly connected to the first cam track, the further cam track having a cam profile which complements the first cam track, and the further cam track being offset with respect to the first cam track in the direction of rotation, and in that the lever (3a, 3b) additionally carries on its second arm (33a, 33b) a second, freely rotating roller (4a, 4b) which abuts, with a corresponding offset, against the further cam track on the end face of a cam plate (21a, 21b), and in that the positions of the cam tracks, which are associated with different tools, in the direction of rotation are matched to one another in such a way that it is true for at least some of the tool halves (12 or 13) that the acceleration phase of one tool half in one tool coincides with the deceleration phase of another tool half in another tool.

3. Machine according to Claim 1 or 2, characterized in that in groups of tool halves which are arranged one after the other along the axis (5) of the cam plates (21a, 21a', 21a", 21b, 21b', 21b"; 22a, 22a', 22a"; 22b, 22b', 22b"), the position of the cams of the cam plates associated with the one group is matched in such a way that, both during the working stroke and during the idle stroke of the tools, the deceleration phase of one tool half coincides with the acceleration phase of the tool half which follows next.

4. Machine according to Claim 1 or Claim 1 and 3, characterized in that for the two halves (12, 13) of a tool, the position of the cams of the respective cam plates (22a, 22b) is matched in such a way that, during the working stroke, the acceleration phase of the first tool half (13) coincides with the deceleration phase of the second tool half (12), whereas, during the idle stroke, the deceleration phase of the first tool half (13) coincides with the acceleration phase of the second tool half (12).

5. Machine according to Claim 1 or Claim 1 and 3, characterized in that for the two halves (12, 13) of a tool, the position of the respective cam tracks is matched in such a way that, during both the working stroke and the idle stroke, the acceleration phase of one of the tool halves coincides with the deceleration phase of the other tool half.

6. Machine according to any one of the preceding claims, characterized in that the axes of the second rollers (4a, 4b) are located approximately on a normal, passing through the axis of the cam tracks, to the direction of motion Z of the tool halves (12, 13), close to the tool halves (12, 13).

7. Machine according to any one of the preceding claims, characterized in that the stationary part (8) of the cam drive is a tie-rod preferably fixed relative to the frame.

8. Machine according to any one of the preceding claims, characterized in that the guide means (1) for the tools extends between the latter and the cam tracks and the second roller(s) (4a, 4b) is (are) located close below the guide means (1) or a tool clamping plate (8).

9. Machine according to any one of the preceding claims, characterized in that the second roller(s) (4a, 4b) is (are) located, with respect to the axis of the cam tracks (22b), at a 90° position relative to the first rollers (6a, 6b).

10. Machine according to any one of the preceding claims, characterized in that the second rollers (4a, 4b) are smaller in diameter than the first rollers (6a, 6b).

11. Machine according to any one of the preceding claims, characterized in that the clamping plate (8) is the tie-rod on which the levers (3a, 3b) are pivotably supported.

12. Machine according to any one of claims 8 to 11, characterized in that the clamping plate (8) extends horizontally.

13. Machine according to any one of the preceding claims, characterized in that the second rollers (4a, 4b) are immediately adjacent to the clamping plate (8).

14. Machine according to any one of the preceding claims, characterized in that the clamping plate (8) has a recess (18) into which the second rollers (4a, 4b) protrude.

15. Machine according to any one of the preceding claims, characterized in that the levers (3a, 3b) are supported in bearing blocks (7) which can be displaced parallel to the axis of the cam tracks, in particular along the clamping plate (8).

16. Machine according to any one of the preceding claims, characterized in that the arm (33a, 33b) of the levers (3a, 3b) which carries the rollers (6a, 6b, 4a, 4b) is branched into a main arm (3a, 3b) carrying the first roller (6a, 6b) and a secondary arm (35a, 35b) which carries the second roller (4a, 4b) and is weaker than the first arm.

17. Machine according to Claim 16, characterized in that the rollers (6a, 6b, 4a, 4b) abut without clearance against the cam plates (21a, 21b, 22a, 22b) by means of pressure.

18. Machine according to any one of the preceding claims, characterized in that at least the first rollers (6a, 6b), and preferably also the second rollers (4a, 4b), are supported in their lever (3a, 3b) on both sides.

19. Machine according to any one of the preceding claims, characterized in that the two rollers (6a, 6b) are located approximately diametrically relative to the respective cam track pair and with their axes in a plane extending approximately parallel to the direction of motion (Z) of the tools.

## Revendications

1. Machine-outil équipée d'outils pour exécuter des travaux d'estampage, de coupe, de découpage et/ou de formage, en particulier pour estamper et former les petites branches de connexion des circuits de commutation intégrés (Ics),
composée d'un bâti (10),
d'une commande à cames montée sur le bâti (10) avec plusieurs paires de voies curvilignes disposées sur le même axe sur la partie frontale d'un ou plusieurs disques à cames (21a, 21b, 22a, 22b) destinés à entraîner les outils le long d'un dispositif de guidage (1), chaque outil étant formé de deux moitiés d'outil (12, 13) fonctionnant l'une contre l'autre et actionnées par deux leviers (3a, 3b) pivotants à deux branches, montés sur une pièce immobile (8) de la commande à cames, chaque première branche (23a, 23b) est reliée à chaque moitié d'outil (12, 13) et chaque deuxième branche (33a, 33b) porte une poulie (6a, 6b) librement pivotante, l'une des poulies (6a) étant placée contre une voie curviligne et l'autre poulie (6b) contre l'autre voie curviligne d'une paire de voies curvilignes, caractérisée en ce que
des paires de voies curvilignes ont été prévues, l'autre voie curviligne étant reliée par un montage fixe à la première voie curviligne, l'autre voie curviligne ayant un profil incurvé complémentaire à celui de la première voie curviligne et l'autre voie curviligne étant décalée par rapport à la première voie curviligne dans le sens de la rotation, et en ce que les deux leviers (3a, 3b) sont encore munis chacun sur leur deuxième branche (33a, 33b) d'une deuxième poulie (4a, 4b) librement pivotante, laquelle se place avec un décalage correspondant contre l'autre voie curviligne sur la surface frontale d'un disque à cames (21a, 21b) et en ce que la position des voies curvilignes dans le sens de la rotation est définie l'une par rapport à l'autre de telle sorte que, pour au moins une partie des moitiés d'outil (12, 13), s'applique le principe qu'une phase d'accélération d'une moitié d'outil coïncide avec une phase de décélération de l'autre moitié d'outil.

2. Machine-outil équipée d'outils pour exécuter des travaux d'estampage, de coupe, de découpage et/ou de formage, en particulier pour estamper et former les petites branches de connexion des circuits de commutation intégrés (Ics),
composée d'un bâti (10),
d'une commande à cames montée sur le bâti (10) avec plusieurs paires de voies curvilignes disposées sur le même axe sur la partie frontale d'un ou plusieurs disques à cames (21a, 21b, 22a, 22b) destinés à entraîner les outils le long d'un dispositif de guidage (1), chaque outil étant formé de deux moitiés d'outil (12, 13) fonctionnant l'une contre l'autre, l'une est immobile et l'autre est actionnée par un levier (3a ou 3b) pivotant à deux branches, monté sur une pièce immobile (8) de la commande à cames, la première branche (23a ou 23b) est reliée à la moitié d'outil (12 ou 13) mobile et la deuxième branche (33a ou 33b) porte une poulie (6a ou 6b) librement pivotante, qui est placée contre la voie curviligne qui correspond à l'outil concerné, caractérisée en ce que
des paires de voies curvilignes ont été prévues, l'autre voie curviligne étant reliée par un montage fixe à la première voie curviligne, l'autre voie curviligne ayant un profil incurvé complémentaire à celui de la première voie curviligne et l'autre voie curviligne étant décalée par rapport à la première voie curviligne dans le sens de la rotation, et en ce que le levier (3a, 3b) est muni sur sa deuxième branche (33a, 33b) d'une deuxième poulie (4a, 4b) librement pivotante, laquelle se place avec un décalage correspondant contre l'autre voie curviligne sur la surface frontale d'un disque à cames (21a, 21b) et en ce que la position des voies curvilignes dans le sens de la rotation est définie l'une par rapport à l'autre de telle sorte que pour au moins une partie des moitiés d'outil (12 ou 13) s'applique le principe qu'une phase d'accélération d'une moitié d'outil dans un outil coïncide avec une phase de décélération de l'autre moitié d'outil dans un autre outil.

3. Machine selon la revendication 1 ou 2, caractérisée en ce que dans des groupes de moitiés d'outils, qui sont disposés l'un derrière l'autre le long de l'axe (5) des disques à cames (21a, 21a', 21a" ; 21b, 21b', 21b" ; 22a, 22a', 22a" ; 22b, 22b', 22b"), la position des courbes des disques à cames appartenant à un groupe est définie de telle sorte que non seulement pendant la course de travail, mais aussi pendant une course à vide des outils, la phase de décélération d'une moitié d'outil coïncide avec la phase d'accélération de la moitié d'outil directement consécutive.

4. Machine selon la revendication 1 ou selon les revendications 1 et 3, caractérisée en ce que dans les deux moitiés (12, 13) d'un outil, la position des courbes des disques à cames (22a, 22b) correspondants est définie de telle sorte que pendant une course de travail, la phase d'accélération de la première moitié d'outil (13) coïncide avec la phase de décélération de la deuxième moitié d'outil (12), alors que, par contre, pendant la course à vide, la phase de décélération de la première moitié d'outil (13) coïncide avec la phase d'accélération de la deuxième moitié d'outil (12).

5. Machine selon la revendication 1 ou selon les revendications 1 et 3, caractérisée en ce que dans les deux moitiés (12, 13) d'un outil, la position de la voie curviligne correspondante est définie de telle sorte que pendant une course de travail, de même que pendant une course à vide, la phase d'accélération de l'une des moitiés d'outil coïncide avec la phase de décélération des l'autre moitié d'outil.

6. Machine selon l'une quelconque des revendications précédentes, caractérisée en ce que les deuxièmes poulies (4a, 4b) se trouvent avec leurs axes approximativement sur une verticale qui traverse l'axe de la voie curviligne sur le sens du mouvement Z des moitiés d'outils (12, 13) proches de ceux-ci.

7. Machine selon l'une quelconque des revendications précédentes, caractérisée en ce que la partie immobile (8) de la commande à cames est de préférence une diagonale fixe sur le châssis.

8. Machine selon l'une quelconque des revendications précédentes, caractérisée en ce que le dispositif de guidage (1) destiné aux outils s'étend entre ceux-ci et les voies curvilignes et que le(s) deuxième(s) poulie(s) (4a, 4b) se situe(nt) directement au-dessous du dispositif de guidage (1) ou d'une plaque de fixation (8) pour outils.

9. Machine selon l'une quelconque des revendications précédentes, caractérisée en ce que le(s) deuxième(s) poulie(s) (4a, 4b) se trouve(nt) par rapport à l'axe des voies curvilignes dans une position à 90° par rapport à la première poulie (6a, 6b).

10. Machine selon l'une quelconque des revendications précédentes, caractérisée en ce que le diamètre des deuxièmes poulies (4a, 4b) est plus petit que celui des premières poulies (6a, 6b).

11. Machine selon l'une quelconque des revendications précédentes, caractérisée en ce que la plaque de fixation (8) représente la diagonale, contre laquelle sont placés les leviers (3a, 3b) pivotants.

12. Machine selon l'une des revendications 8 à 11, caractérisée en ce que la plaque de fixation (8) est orientée horizontalement.

13. Machine selon l'une quelconque des revendications précédentes, caractérisée en ce que les deuxièmes poulies (4a, 4b) se situent directement à proximité de la plaque de fixation (8).

14. Machine selon l'une quelconque des revendications précédentes, caractérisée en ce que la plaque de fixation (8) est formée d'un creux (18) dans lequel s'engagent les deuxièmes poulies (4a, 4b).

15. Machine selon l'une quelconque des revendications précédentes, caractérisée en ce que les leviers (3a, 3b) sont logés dans des supports (7), qui peuvent être déplacés parallèlement à l'axe des voies curvilignes, en particulier le long de la plaque de fixation (8).

16. Machine selon l'une quelconque des revendications précédentes, caractérisée en ce que la branche (33a, 33b) des leviers (3a, 3b), qui porte les poulies (6a, 6b, 4a, 4b), se sépare en une branche principale (3a, 3b), qui porte la première poulie (6a, 6b) et une branche auxiliaire (35a, 35b) plus petite que la première et qui porte la deuxième poulie (4a, 4b).

17. Machine selon la revendication 16, caractérisée en ce que les poulies (6a, 6b, 4a, 4b) sont placées par pression sans jeu contre les disques à cames (21a, 21b, 22a, 22b).

18. Machine selon l'une quelconque des revendications précédentes, caractérisée en ce qu'au moins les premières poulies (6a, 6b), de préférence aussi les deuxièmes poulies (4a, 4b) sont logées de part et d'autre dans leur levier (3a, 3b).

19. Machine selon l'une quelconque des revendications précédentes, caractérisée en ce que les deux poulies (6a, 6b) par rapport à la paire de voies curvilignes correspondant sont disposées pratiquement diamétralement ainsi qu'avec leurs axes dans un plan orienté à peu près parallèlement par rapport au sens du mouvement de l'outil (2).
